# EUROPEAN PATENT APPLICATION

(11) **EP 2 439 250 A1**
(43) Date of publication of application: **11.04.2012**
(21) Application number: 10783212.3
(22) Date of filing: 14.04.2010
(51) Int. Cl.: C09K 11/00, C09K 11/02, C09K 11/54, C30B 19/02, C30B 29/22, C30B 33/00, G01T 1/20, G01T 1/202

(54) **MULTILAYER ZnO SINGLE CRYSTAL SCINTILLATOR AND METHOD FOR MANUFACTURING SAME**

(30) Priority: 04.06.2009 JP 2009135468
(71) Applicant: Mitsubishi Gas Chemical Company, Inc., Tokyo 100-8324 (JP); Tohoku University, Aoba-ku Sendai-shi Miyagi 980-8577 (JP)
(72) Inventor: SEKIWA Hideyuki, Tokyo 125-8601 (JP); KOBAYASHI Jun, Tokyo 125-8601 (JP); MIYAMOTO Miyuki, Tokyo 125-8601 (JP); TOKUTAKE Taichi, Tokyo 125-8601 (JP); YOSHIKAWA Akira, Sendai-shi Miyagi 980-8577 (JP); YANAGIDA Takayuki, Sendai-shi Miyagi 980-8577 (JP)
(74) Representative: Vossius & Partner
(86) International application number: PCT/JP2010/056671
(87) International publication number: WO 2010/140426

(57) **Abstract**

Provided are a multilayer ZnO single crystal scintillator wherein the light emitting quantity is increased, and a method for manufacturing such scintillator. A multilayer body composed of ZnO semiconductor layers having different band gaps is manufactured, and a layer having a small band gap is made to have a thickness that permits ionization radiation, such as α rays and electronic rays, to enter the layer, thereby the light emitting quantity of the multilayer ZnO single crystal scintillator is greatly increased.

## Description

### TECHNICAL FIELD

The present invention relates to a multilayer ZnO single crystal which is used as a scintillator for a scintillation detector.

### BACKGROUND ART

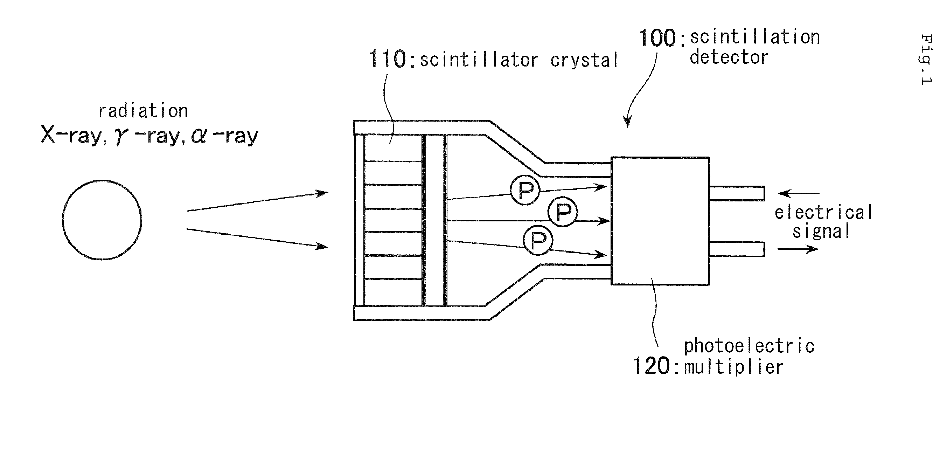

As a device for measuring radiation, there is a scintillation detector. Constitution of a typical scintillation detector is shown in FIG. 1. In FIG. 1, when radiation enters the scintillation detector 100, fluorescence is emitted from the scintillator crystal 110 in response to the incident radiation, and by detecting the fluorescence using a photoelectric multiplier tube or the semiconductor detector 120, radiation detection can be achieved.

As a candidate for scintillator · device of next generation, TOF (Time of Flight) mode has been suggested and studies are made regarding fluorides. For performing time resolution, the shorter the fluorescence lifetime is, the more the resolution is improved, and BaF₂ is believed to be the most ideal candidate. However, as BaF₂ has a small light emission quantity and short emission wavelength, an expensive photoelectric multiplier tube (PMT) equipped with a quartz window is necessary, and therefore there is a problem that a common PMT cannot be used, etc.

In this connection, as a scintillator having short fluorescence lifetime which can substitute BaF₂, an exciton light emitting scintillator of a wide band gap compound semiconductor is suggested. When a compound semiconductor such as ZnO and CdS is used as a scintillator, the fluorescence lifetime is shortened and the emission wavelength is modified to 370 nm, so that a common PMT or a semiconductor detector can be used.

Meanwhile, as an application of scintillation, there is a use for identifying distribution of radioactive resulting from a contaminating material. Conventionally, an autoradiography (ARG) or an imaging plate is used for the identification. Although they are advantageous in that they have been used for several decades and thus have stable performance, there is also a problem that the former requires a development film and the radioactive intensity cannot be known from the film. Further, although it is convenient to use, the latter needs a big-scale measurement device for analysis. Still further, as a measurement sample needs to be produced from an object to be measured (i.e., contaminated material) and placed in a device and the exposure time should be determined in advance (i.e., a suitable exposure time should be estimated), there is a problem that on-site identification is impossible and it takes time to obtain the results.

With regard to these passive measurement devices, if it is possible that radiation is detected on real-time basis to emit light, which is then converted into an electric signal, it can be used for early detection of radioactive contamination and quick response.

As a means for solving the problems above, an exciton light emitting scintillator of a wide band gap compound semiconductor was suggested by Derenzo, et. al. (Non-Patent Literature 1; Nuclear Instruments and Methods in Physics Research A505 (2003) 111-117, and Patent Literature 1; US Patent Application Publication No. 2006/219928).

When a wide band gap compound semiconductor such as ZnO and CdS is used as a scintillator, the fluorescence lifetime is shortened and the emission wavelength is modified to 370 to 380 nm, so that a common PMT or a semiconductor detector can be used. According to the same literatures, the lifetime of fluorescence caused by X ray excitation is as short as 0.11 nsec to 0.82 nsec. However, the scintillator material described in the literatures is a polycrystal. In case of a polycrystal, emission intensity can be fluctuating according to the direction of fine crystals, etc. , and thus it has a problem that the spatial resolution power may vary depending on particle diameter. To achieve high spatial resolution power and effective light emission from a scintillator, it is preferable that the scintillator is composed of a single crystal.

Meanwhile, use of ZnO single crystal doped with an element of Group III of the Periodic Table and lanthanoid in an amount of about 1 ppm to 10 mol% for an exciton light emitting scintillator is suggested (Patent Literature 2; International Application No. 2007/094785 and Non-Patent Literature 2; Nuclear Instruments and Methods in Physics Research A505 (2003) 82-84).

According to the literatures above, it is described that the fluorescence lifetime of the ZnO single crystal doped with In is 0.6 nsec. However, the scintillator material described in the literatures is produced according to "High pressure direct melting technique." According to the same method, as high pressure and high temperature are required and cost for growing crystals is high and also a single crystal part and a polycrystal part are present as a mixture, the same problems as described above for the polycrystal also exist.

As a method of solving the problems of a polycrystal, a scintillator which uses exciton light emission of a wide band gap ZnO single crystal is suggested (Patent Literature 3; International Publication No. 2005/114256, Non-Patent Literature 3; Research Result Report of 2005 by New Energy and Industrial Technology Development Organization, "Development of ultra-high speed scintillator single crystal material for practical TOF detector").

According to the same report, a hydrothermal synthesis using an autoclave having Pt in the inside is employed as a method of growing ZnO single crystal. By using this growth method, it is possible to grow ZnO single crystal doped with an element of Group III of the Periodic Table so that the crystal can have high crystallinity and a big size. However, in the exciton light emitting scintillator using ZnO, etc. , there is a problem that emission quantity is low due to self absorption. In other words, as the crystal itself acts as an absorbing body within a wavelength region of exciton light emission, the scintillator emission quantity is decreased in particular in a transmission type scintillator device. As such, the emission quantity from the ZnO exciton emission scintillator is only about 10 to 15% of Bi₄Ge₃O₁₂ (BGO), which is one of the scintillators generally used (Non-Patent Literature 4; High Energy News Vol. 21, No. 2, 41-50 2002).

Meanwhile, when a laser pulse deposition (PLD) or a gas phase growth method such as MBE and MOCVD is used, it is possible to grow ZnO single crystal with high quality. However, the gas phase growth method has a problem that film production speed is slow and it takes a lot of time to grow ZnO single crystal having film thickness of 1 µm or more. In case of ZnO single crystal, as a rays or electronic rays has entrance depth of 5 to 50 µm, a sufficient thickness to prevent α rays or electronic rays cannot be provided within a short time by growing only ZnO single crystal according to a gas phase growth method.

### PRIOR ART LITERATURES

### PATENT LITERATURES

Patent Literature 1: US Patent No. 2006/219928
Patent Literature 2: International Publication No. 2007/094785
Patent Literature 3: International Publication No. 2005/114256
Patent Literature 4: Japanese Patent Application Laid-Open (JP-A) No. 2008-230906

### NON-PATENT LITERATURES

Non-Patent Literature 1: Nuclear Instruments and Methods in Physics Research A505 (2003) 111-117
Non-Patent Literature 2: Nuclear Instruments and Methods in Physics Research A505 (2003) 82-84
Non-Patent Literature 3: Research Result Report of 2005 by New Energy and Industrial Technology Development Organization, "Development of ultra-high speed scintillator single crystal material for practical TOF detector"
Non-Patent Literature 4: High Energy News Vol. 21 No. 2, 41-50, 2002
Non-Patent Literature 5: Appl. Phys. Lett. 78 1237 (2001)

### SUMMARY OF THE INVENTION

### PROBLEMS TO BE SOLVED BY THE INVENTION

Under the circumstances described above, a development of a multilayer ZnO single crystal scintillator with increased light emission quantity and a method for manufacturing the same is required.

### MEANS FOR SOLVING THE PROBLEMS

Inventors of the invention previously filed a patent application relating to a multilayer body which contains Mg-containing ZnO semiconductor (Patent Literature 4; JP-A No. 2008-230906). When the method of this application is used, a multilayer body of ZnO single crystal with different band gaps can be produced. As a result of intensive studies, the inventors found that, by manufacturing a multilayer body of ZnO semiconductor having different band gaps wherein a layer having a small band gap is made to have a thickness that permits entrance of ionization radiation, such as α rays or electronic rays, the light emission quantity can be greatly increased, and therefore completed the invention.

### EFFECT OF THE INVENTION

According to a preferred embodiment of the invention, a multilayer ZnO single crystal scintillator and a method for manufacturing such scintillator can be provided, wherein the multilayer body composed of ZnO semiconductor having different band gaps is manufactured, and a layer having a small band gap is made to have a thickness that permits ionization radiation, such as α rays and electronic rays, to enter the layer, thereby the light emission quantity is greatly increased.

### BRIEF DESCRIPTION OF THE DRAWINGS

FIG. 1 illustrates a constitution of a typical scintillation detector.
FIG. 2 illustrates a typical Liquid phase epitaxial (LPE) growth furnace that is used in a third, fourth, and fifth embodiments of the invention.
FIG. 3 illustrates the construction of the LPE growth furnace used in the Examples.

### BEST MODES FOR CARRYING OUT THE INVENTION

Herein below, the invention will be explained in detail. A compound semiconductor such as ZnO generates exciton light emission according to band gap when it is irradiated with ionization radiation such as α rays or electronic rays. Band gap of pure ZnO is about 3.30 eV. The exciton light emission itself is absorbed by ZnO itself, and it hardly penetrates to reach a surface that is opposite to the surface irradiated with ionization radiation. As such, the scintillator light which penetrates to reach a surface that is opposite to the surface irradiated with long wavelength component of an exciton light emission is basically the only component which contributes to the light emission quantity of a scintillator, and the light emission quantity of an exciton emission scintillator is relatively small. Although the invention is not limited by this principle, the light emission quantity of a scintillator can be increased by relaxing the self-absorption.

### <First embodiment>

The first embodiment of the invention is a multilayer ZnO single crystal scintillator which is a multilayer body including at least two layers of ZnO mixed crystal (Zn_{1-x-y}MgₓCd_{y})O having different band gaps, **characterized in that** the ZnO mixed crystal layer with a smaller band gap has an irradiation surface for ionization radiation, thickness of 5 µm to 50 µm, and 0 ≤ x ≤ 0.145 and 0 ≤ y ≤ 0.07.

As suggested before by the inventors, by using mixed crystals of Zn and Mg, it becomes possible to control the band gap to 3.30 to 3.54 eV. Meanwhile, by using mixed crystals of Zn and Cd, it becomes possible to control the band gap to 3.00 to 3.30 eV (Non-Patent Literature 5; Appl. Phys. Lett. 78 1237 (2001)). Thus, when a multilayer body is formed by including at least two layers of ZnO mixed crystal (Zn_{1-x-y}MgₓCd_{y})O having different band gaps, ionization radiation is irradiated to a surface of a layer with a smaller band gap (i.e., irradiation surface), and thickness of the (Zn_{1-x-y}MgₓCd_{y})O layer irradiated with ionization radiation is adjusted to 5 µm to 50 µm, the thickness that permits entrance of ionization radiation. The ionization radiation is absorbed by a layer with a small band gap for conversion into a scintillator light. As the second and further layers counting from the layer irradiated with ionization radiation have a larger band gap compared to the layer emitting the scintillator light (i.e., the first layer), a greater amount of scintillator light can enter them.

The thickness of the layer irradiated with ionization radiation is from 5 µm to 50 µm, preferably from 10 µm to 45 µm, and more preferably 20 µm to 40 µm. When the thickness of the layer irradiated with ionization radiation is less than 5 µm, the ionization radiation enters the second layer (or further layers) so that part of the ionization radiation emits scintillator light from the second or further layer. However, as the scintillator light emitted from the second or further layer has a wavelength that is determined by the band gap of each layer of the second and further layers, eventually self-absorption occurs to lower the total light emission quantity, and therefore undesirable. On the other hand, when the thickness of the layer irradiated with ionization radiation is more than 50 µm, the whole ionization radiation is absorbed by the first layer. However, the emitted scintillator light progresses into the first layer to cause self-absorption eventually, and therefore undesirable too.

The number of ZnO mixed crystal layer (Zn_{1-x-y}MgₓCd_{y})O to be laminated can be three or more. However, for such case, it is desirable to laminate a layer with a small band gap first from the viewpoint of increasing light emission quantity.

Herein, to increase a light emission quantity from an exciton light emitting scintillator single crystal, a single crystal with high crystallinity is required. As the liquid phase epitaxial method (LPE method) is close to thermal equilibrium growth, it allows growth of ZnO single crystal with relatively high crystallinity. However, solid dissolution of Mg or Cd over equilibrium solid dissolution limit is difficult to achieve. As disclosed in Patent Literature 4 by the inventors of the invention, the equilibrium solid dissolution amount of MgO compared to ZnO is 0 ≤ x ≤ 0.145. When x is greater than 0.145, single phase of MgO precipitates, and therefore undesirable. In addition, as disclosed in Non-Patent Literature 4, the equilibrium solid dissolution amount of CdO compared to ZnO is 0 ≤ y ≤ 0.07. When y is greater than 0.07, single phase of CdO precipitates, and therefore undesirable.

Specifically, by having a hydrothermal synthesis ZnO single crystal substrate, which is provided with high quality and large area, as a seed crystal substrate, a thick layer of (Zn, Mg)o mixed crystal having a larger band gap than ZnO is grown on the substrate, and the hydrothermal synthesis ZnO single crystal present on the substrate is etched or polished to manufacture a desired multilayer body of ZnO single crystal having different band gaps. Further, by growing (Zn, Cd)O mixed crystal having a smaller band gap than ZnO on a hydrothermal synthesis ZnO single crystal substrate and etching or polishing the (Zn, Cd)O layer to desired thickness, a desired multilayer body of ZnO single crystal having different band gaps can be manufactured.

Examples of the ionization radiation that can be irradiated onto the multilayer ZnO single crystal scintillator include α rays, y rays, electronic rays, X rays, and neutron rays.

### <Second embodiment>

The second embodiment of the invention relates to the multilayer ZnO single crystal scintillator which contains at least one selected from a group including Al, Ga, In, H, F and lanthanoid.

Within a ZnO single crystal, an n-type crystal defect such as zinc or oxygen pores is present between lattices, and when ionization radiation such as α rays or electronic rays is irradiated onto the crystal defect, light emission having long decay lifetime in the wavelength range of 450 to 600 nm occurs. Since this long-wavelength light emission has long fluorescence lifetime, it is disadvantageous in that stability for a discrimination function of radiation detection is lowered.

In this regard, when ZnO single crystal doped with an element of Group III of the Periodic Table, hydrogen, fluorine, and a lanthanoid element is used like this embodiment, exciton light emitting ZnO single crystal which shows small light emission in the range of 450 to 600 nm can be manufactured. Specifically, only the exciton light emission having short fluorescence lifetime at the time of excitation by ionization radiation such as α rays or electronic rays becomes dominant, and therefore a light emitting component with long fluorescence lifetime is decreased. As a result, discrimination function of radiation detection can be stabilized. The ZnO single crystal scintillator obtained from this embodiment can be applied for a detector which uses high speed α rays or electronic rays.

### <Third embodiment>

The third embodiment of the invention is a method for manufacturing a multilayer ZnO single crystal scintillator which is a multilayer body including at least two layers of ZnO mixed crystal (Zn_{1-x-y}MgₓCd_{y})O having different band gaps, wherein the ZnO mixed crystal layer with a smaller band gap has an irradiation surface for ionization radiation, thickness of 5 µm to 50 µm, and 0 ≤ x ≤ 0.145 and 0 ≤ y ≤ 0.07, **characterized in that** at least one layer of the multilayer body is produced by a liquid phase epitaxial growth method which includes directly contacting a substrate with a mixture · molten material of ZnO, MgO and CdO as a solute and PbO and Bi₂O₃ as a solvent to grow ZnO mixed crystal (Zn_{1-x-y}MgₓCd_{y})O on the substrate.

Specifically, it is a method for manufacturing a multilayer body including two or more layers of ZnO mixed crystal (Zn_{1-x-y}MgₓCd_{y})O having different band gaps according to the LPE method in which ZnO, MgO and CdO as a solute and PbO and Bi₂O₃ as a solvent are admixed with one another and melted, a seed crystal or substrate is brought into direct contact with a molten liquid obtained, and temperature is lowered to precipitate the ZnO mixed crystal (Zn_{1-x-y}MgₓCd_{y})O in a supersaturated molten liquid for its growth on the substrate.

According to this embodiment, the LPE method that is close to thermal equilibrium growth is used as a method for growing crystals and a solvent including large ionic radius such as PbO and Bi₂O₃, which cannot easily enter the ZnO crystal, is used and therefore ZnO single crystal with high quality in which the amount of impurities inside the crystal is small can be manufactured. In particular, ZnO single crystal with high quality in which the fluorine impurities are reduced can be manufactured. The multilayer body including at least two layers of ZnO mixed crystal (Zn_{1-x-y}MgₓCdy)O having different band gaps obtained from this embodiment can be applied for a high speed detector using α rays or electronic rays, etc., and therefore light emission quantity can be increased.

The solvent composition is preferably such that PbO : Bi₂O₃ = 0.1 to 95 mol% : 99.9 to 5 mol%. More preferably, it is PbO : Bi₂O₃ = 30 to 90 mol% : 70 to 10 mol%, and particularly preferably PbO : Bi₂O₃ = 60 to 80 mol% : 40 to 20 mol%. In a single solvent of PbO or Bi₂O₃, liquid phase growth temperature increases. Thus, the mixture solvent of PbO and Bi₂O₃ having the mixing ratio above is preferable.

The mixing ratio between the solvent of ZnO, MgO and CdO and the solute of PbO and Bi₂O₃ is preferably such that the solute expressed in terms of only ZnO : solvent = 5 to 30 mol% : 95 to 70 mol%. More preferably, the solute concentration is from 5 mol% to 10 mol%. When the solute concentration is less than 5 mol%, the growth rate is slow. On the other hand, when it is greater than 30 mol%, the growth temperature may increase. Further the expression "solute expressed in terms of only ZnO" indicates [ZnO (mol)]/([zno (mol)]+[PbO (mol)] + [Bi₂O₃ (mol)]).

### <Fourth embodiment>

The fourth embodiment of the invention is a method for manufacturing a multilayer ZnO single crystal scintillator which is a multilayer body including at least two layers of ZnO mixed crystal (Zn_{1-x-y}MgₓCd_{y})O having different band gaps, wherein the ZnO mixed crystal layer with a smaller band gap has an irradiation surface for ionization radiation, thickness of 5 µm to 50 µm, and 0 ≤ x ≤ 0.145 and 0 ≤ y ≤ 0.07, **characterized in that** at least one layer of the multilayer body is produced by a liquid phase epitaxial growth method which includes directly contacting a substrate with a mixture · molten material of ZnO, MgO and CdO as a solute and PbF₂ and PbO as a solvent to grow ZnO mixed crystal (Zn_{1-x-y}MgₓCd_{y})O on the substrate.

Specifically, it is a method for manufacturing a multilayer body including two or more layers of ZnO mixed crystal (Zn_{1-x-y}MgₓCd_{y})O having different band gaps according to the LPE method in which ZnO, MgO and CdO as a solute and PbF₂ and PbO as a solvent are admixed with one another and melted, a seed crystal or substrate is brought into direct contact with a molten liquid obtained, and temperature is lowered to precipitate the ZnO mixed crystal (Zn_{1-x-y}MgₓCd_{y})O in a supersaturated molten liquid for its growth on the substrate.

The solvent composition is preferably such that PbF₂ : PbO = 80 to 20 mol% : 20 to 80 mol%. More preferably, it is PbF₂ : PbO = 70 to 30 mol% : 30 to 70 mol% and particularly preferably PbF_{2 :} PbO = 60 to 40 mol% : 40 to 60 mol%. When the mixing ratio of the solvent is within the range above, evaporation amount of PbF₂ and PbO as a solvent can be suppressed, and therefore a fluctuation in solute concentration becomes small. As a result, ZnO mixed single crystal can be grown in a stable manner.

The mixing ratio between ZnO, MgO and CdO as a solute and PbF₂ and PbO as a solvent is preferably such that the solute expressed in terms of only ZnO : solvent = 2 to 20 mol% : 98 to 80 mol%. More preferably, the solute concentration is from 5 mol% to 10 mol%. When the solute concentration is less than 5 mol%, the effective growth rate is slow. On the other hand, when it is greater than 20 mol%, the temperature to dissolve the solute component may increase, yielding a high amount of evaporated solvent.

### <Fifth embodiment>

The fifth embodiment of the invention is a method for manufacturing a multilayer ZnO single crystal scintillator, **characterized in that** ZnO mixed crystal (Zn_{1-x-y}MgₓCd_{y})O having different composition from the ZnO mixed crystal as a substrate is grown on ZnO mixed crystal (Zn_{1-x-y}MgₓCd_{y})O to manufacture a multilayer body, and thickness of ZnO mixed crystal layer having a smaller band gap is adjusted to 5 µm to 50 µm by polishing or etching.

As described above in the first embodiment, by having a hydrothermal synthesis ZnO single crystal substrate as a seed crystal substrate, a thick layer of (Zn, Mg)O mixed crystal having a larger band gap than ZnO is grown on the substrate, and the hydrothermal synthesis ZnO single crystal used as a substrate is etched or polished to manufacture a desired multilayer body of ZnO single crystal having different band gaps. Further, by growing (Zn, Cd)O mixed crystal having a small band gap on a hydrothermal synthesis ZnO single crystal substrate and etching or polishing the (Zn, Cd)O layer to desired thickness, a desired multilayer body of ZnO single crystal having different band gaps can be manufactured. According to these methods, only one trial of LPE growth is enough so that they are excellent in terms of reducing number or reaction steps and cost required.

However, in case of excitation using α rays or electronic rays on a hydrothermal synthesis substrate, there is a problem that light emission with long fluorescence lifetime occurs in the range of 450 to 600 nm. Thus, it is also possible that a (Zn_{1-x-y}MgₓCd_{y})O layer is first formed on a hydrothermal synthesis substrate according to the method described in the first embodiment, the hydrothermal synthesis substrate used for LPE growth is completely removed by etching or polishing, and an additional (Zn_{1-x-y}MgₓCd_{y})O layer having a different band gaps may be formed on the LPE growth film as a substrate. In such case, it is also possible that the layer to which ionization radiation such as α rays or electronic rays enters is doped with an element of Group III of the Periodic Table or a lanthanoid element to suppress the occurrence of long wavelength light emitting component.

### <Crystal growth method suitable for the invention>

As a method of growing ZnO single crystal, a gas phase growth method and a liquid phase growth method are mainly used. As a gas phase growth method, a chemical gas phase transport method (see, JP-A No. 2004-131301), a molecular beam epitaxy or an organometallic gas phase growth method (see, JP-A No. 2004-84001), or a sublimation method (see, JP-A No. 5-70286), etc. has been used. However, as having many transition and defects, etc., quality of the crystal remains unsatisfactory.

Meanwhile, crystal growth progresses in thermal equilibrium according to the principle of a liquid phase growth method, and therefore it is advantageous in that high quality crystal can be manufactured more easily compared to the gas phase growth method. However, ZnO has high melting point of about 1975°C and is highly volatile, growing ZnO single crystal by using Czochralski method that is generally used for silicone single crystal, etc. is difficult. For such reasons, as a method of growing ZnO single crystal, methods such as a static and slow cooling method including dissolving a target material in an appropriate solvent, cooling the mixture solution to obtain a saturated state, and growing the target material from the melted solution, or a hydrothermal synthetic method, a flux method, a floating zone method, a Top Seeded Solution Growth (TSSG) method, a solution pulling method, and an LPE growth method are conventionally used.

As a method of growing the single crystal of the ZnO mixed crystal (Zn_{1-x-y}MgₓCd_{y})O of the invention, a liquid phase epitaxial method (LPE method), a flux method, a TSSG method, and a solution pulling method, etc. can be used. Among these various methods, as a method of growing the ZnO mixed crystal (Zn_{1-x-y}MgₓCd_{y})O, the LPE method which allows structure formation of a layer specific to each function is preferable, from the viewpoint of relatively low cost, growth over large area, and application to a scintillator, in particular. Further, a method of growing ZnO mixed crystal (Zn_{1-x-y}MgₓCd_{y})O single crystal by an LPE method using a ZnO single crystal produced by hydrothermal synthetic method, which enables high crystallinity and easy obtainment of a substrate with large area, as a substrate is particularly preferable (i.e., liquid phase homo-epitaxial growth method).

### <LPE growth furnace suitable for the invention>

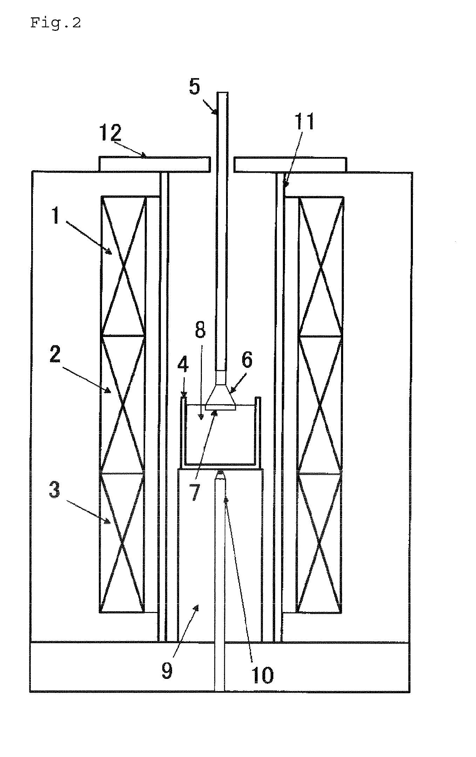

A typical LPE growth furnace that is used for the third, fourth, and fifth embodiments of the invention is shown in FIG. 2. In the LPE growth furnace, a platinum crucible 4 for melting raw materials and containing them as a molten liquid is mounted on the crucible board 9 made of mullite (alumina + silica). A three-stage side heater (a top heater 1, a middle heater 2, and a bottom heater 3) for heating and melting the raw materials contained in the platinum crucible 4 is formed in the external side of the platinum crucible 4. Output of each heater is independently controlled so that heating amount applied on molten liquid is also independently controlled. Between the heater and the inside wall of the manufacturing furnace, the furnace tube 11 made of mullite is formed. On top of the furnace tube 11, the furnace cover 12 made of mullite is formed. A pulling-up device is formed above the platinum crucible 4. On the pulling-up device, a pulling-up shaft 5 made of alumina is fixed, and a substrate holder 6 and a substrate 7 fixed by the holder are formed at the tip of the shaft. A device for rotating the pulling-up shaft is formed above the pulling-up shaft 5.

Conventionally, for members constituting LPE furnace, only the alumina or mullite has been used for the crucible board 9, the furnace tube 11, the pulling-up shaft 5, and the furnace cover 12. As such, in the temperature of 700 to 1100°C which is the temperature of LPE growth or dissolving raw materials, it is believed that Al components volatilize from the alumina or mullite furnace material and dissolved in a solvent to get incorporated into thin film of ZnO single crystal.

Controlling the doping amount of an element of Group III of the Periodic Table is critical in the invention. The doping amount of an element of Group III of the Periodic Table is preferably controlled by composition to be added. Thus, by using a non-Al material as a furnace material constituting the LPE furnace, incorporation of Al impurities into LPE-grown thin film of ZnO single crystal can be reduced. ZnO furnace material is optimal as a non-Al furnace material. However, as it is not commercially available, MgO is suitable as a material which does not function as a carrier even when incorporated to a ZnO thin film. Further, considering the SIMS analysis result showing that Si impurity concentration in LPE film does not increase even when a mullite furnace material including alumina and silica is used, a quartz furnace material is also suitable. In addition, calcia, silica, ZrO₂ and zircon (ZrO₂ + SiO₂), SiC, and Si₃N₄, etc. can be also used.

Based on the above, ZnO mixed crystal (Zn_{1-x-y}MgₓCd_{y})O is manufactured by using a LPE growth furnace including MgO and/or quartz as a non-Al furnace material according to the preferred embodiment of the invention. Further, an embodiment in which the growth furnace has a crucible board to mount a crucible, a furnace tube formed to wrap around the periphery of the crucible board, a furnace cover formed above the furnace tube to cover or open the furnace, and a pulling-up shaft to lift or lower seed crystal or substrate, wherein each member is independently produced with MgO or quartz, is also preferable.

### <Other requirements suitable for the invention>

According to the third, fourth and fifth embodiments of the invention, for the purpose of controlling LPE growth temperature and viscosity of solvent, one or more kinds of a third component can be added to the solvent within the range that ZnO solubility or evaporation amount of PbF₂ and PbO or evaporation amount of PbO and Bi₂O₃ does not greatly change. Examples of the third component include B₂O₃, P₂O₅, V₂O₅, MoO₃, WO₃, SiO₂, MgO, and BaO. Further, Bi₂O₃ may be added as a third component to the solvent of the fourth embodiment of the invention.

The substrate used for the third, fourth and fifth embodiments of the invention is not specifically limited if it has the same kind of crystal structure of ZnO and a thin film for growth and the substrate do not react with each other. A substrate with close lattice constant is suitably used. Examples thereof include sapphire, LiGaO₂ LiAlO₂, LiNbO₃, LiTaO₃, and ZnO. Considering that the target single crystal of the invention is ZnO, ZnO having high lattice match for the substrate and growing crystal is optimal.

### EXAMPLES

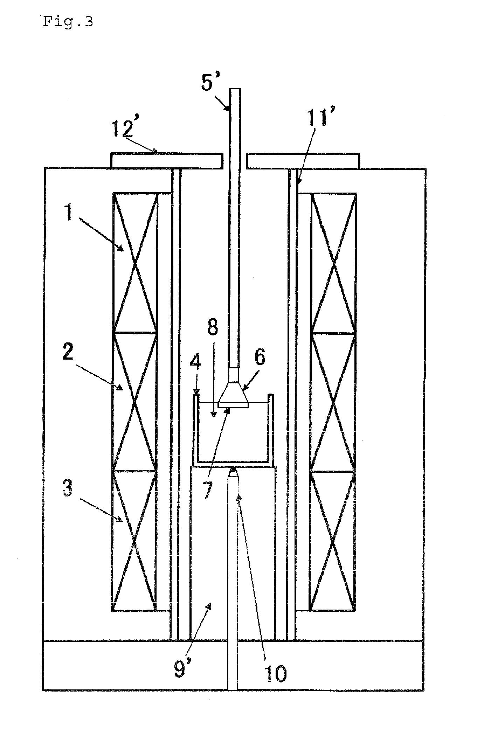

Herein below, as a method of growing a doped ZnO single crystal according to one embodiment of the invention, a method of producing a thin film of ZnO mixed crystal on a ZnO substrate single crystal by LPE method is described. However, the invention is not limited by the Examples given below. The constitutional view of the LPE growth furnace used in the Examples is shown in FIG. 3.

### <Outline of condition for operating LPE growth furnace>

Constitutional view of the LPE growth furnace that is used in the Example is shown in FIG. 3. In the furnace for manufacturing single crystal, the platinum crucible 4 for melting raw materials and containing them as a molten liquid is mounted on the crucible board 9'. A three-stage side heater (a top heater 1, a middle heater 2, and a bottom heater 3) for heating and melting the raw materials contained in the platinum crucible 4 is formed in the external side of the platinum crucible 4. Output of each heater is independently controlled so that heating amount applied on molten liquid is also independently controlled. Between the heater and the inside wall of the manufacturing furnace, the furnace tube 11' is formed. On top of the furnace tube 11' , the furnace cover 12' to cover or open the furnace is also formed. Apulling-up device is formed above the platinum crucible 4. On the pulling-up device, a pulling-up shaft 5' made of quartz is fixed, and the substrate holder 6 and a seed crystal or the substrate 7 fixed by the holder are formed at the tip of the shaft. A device for rotating the pulling-up shaft 5' is formed above the pulling-up shaft 5' made of quartz. A thermocouple 10 to melt the raw materials contained in the crucible is formed below the platinum crucible 4.

In order to melt the raw materials contained in the platinum crucible, temperature of manufacturing furnace is increased until the raw materials melt. Preferably, the temperature is increased up to 800 to 1100°C, and then kept for 2 to 3 hours to stabilize the melt solution of the raw materials. By stirring with a stirring blade made of platinum, keeping time may be shortened. At that time, the three-stage heater is given with an offset so that the temperature of the crucible bottom is several degrees higher than the temperature on the surface of molten liquid. Preferably, it is -100°C ≤ Hl offset ≤ 0°C, 0°C ≤ H3 offset ≤ 100°C, and more preferably -50°C ≤ Hl offset ≤ 0°C, 0°C ≤ H3 offset ≤ 50°C.

The temperature of the crucible bottom is adjusted to the seeding temperature of 700 to 950°C. Once the temperature of the molten liquid is stabilized, the pulling-up shaft is lowered while rotating the substrate at 5 to 120 rpm to bring the substrate into contact with the surface of molten liquid. After fusing the substrate with the molten liquid, the temperature is decreased by constant temperature or 0.025 to 1.0°C/hr to grow the desired ZnO mixed single crystal containing Mg (or containing Cd) on the substrate surface. During the growth, the substrate is still rotated at 5 to 300 rpm by rotation of the pulling-up shaft, and it is also reversely rotated per pre-determined time period.

After the crystal is allowed to grow for 30 minutes to 100 hours, the substrate is removed from the molten liquid and the molten liquid components are separated by rotating the pulling-up shaft at high speed about 200 to 300 rpm. After that, by cooling to room temperature over 1 to 24 hours, a desired thin film of ZnO mixed single crystal containing Mg (or containing Cd) is obtained. Depending on thickness of a growing film, it is also possible that the growth is performed by pulling up the quartz shaft, either over time or continuously.

### <Examples 1 to 4 and Comparative examples 1 to 3>

According to the process given below, Zn_{0.9}Mg_{0.1}O single crystal was manufactured according to the liquid phase epitaxial growth method.

To a platinum crucible having inner diameter of 75 mmφ, height of 75 mmh, and thickness of 1 mm, each of ZnO, MgO, PbO and Bi₂O₃ as a raw material was added in an amount of 32.94 g, 1.81 g, 800.61 g, and 834.39 g, respectively. At that time, concentration of ZnO as a solute was 7 mol%, MgO/(ZnO + MgO) = 10 mol%, and concentration of PbO and Bi₂O₃ as a solvent was PbO _{:} Bi₂O₃ = 66.70 mol% : 33.30 mol%.

The crucible with the raw materials added therein was installed in the furnace shown in FIG. 3 and dissolved by stirring using a Pt stirring jig while the temperature of the crucible bottom is maintained at about 900°C for 1 hour. Then, the temperature was lowered until the temperature of the crucible bottom is about 808°C. As a seed crystal, ZnO single crystal substrate (size: 10 mm x 10 mm x 0.5 mmt, according to +c coordinate) which has been grown by a hydrothermal synthesis method was brought into contact with the liquid and grown for 48 hours at the same temperature while rotating the pulling-up shaft at 60 rpm. The rotation direction of the shaft was reversed every two minutes. After that, by lifting the pulling-up shaft, the substrate was removed from the molten liquid. By rotating the shaft at 100 rpm, the molten liquid components were removed to obtain 250 µm of a colorless and transparent Zn_{0.9}Mg_{0.1}O single crystal film. The growth rate was about 5.2 µm/hr.

Band gap obtained from PL emission wavelength of Zn_{0.9}Mg_{0.1}O produced was 3.46 eV. Further, half width value of the locking curve of the surface (002) was 60 arcsec, and therefore sufficiently high crystallinity was confirmed.

Both surfaces of Zn_{0.9}Mg_{0.1}O (250 µm)/hydrothermal synthesis ZnO substrate (500 µm) obtained were subjected to wrapping and polishing for processing into ZnO mixed crystal multilayer body including Zn_{0.9}Mg_{0.1}O (220 µm)/hydrothermal synthesis ZnO substrate (70 µm) (i.e., a multilayer body of the Comparative example 1). From the hydrothermal synthesis ZnO substrate side having a small band gap, α rays were irradiated and the scintillator emission quantity is compared to that of BGO (Bi₄Ge₃O₁₂) and a hydrothermal synthesis substrate. Thereafter, by increasing polishing amount of the hydrothermal synthesis substrate, thickness of the substrate was adjusted to 50 µm, 30 µm, 10 µm, 5 µm, or 3 µm (each corresponds to the multilayer body of the Examples 1 to 4 and the Comparative example 2). Scintillator characteristics were measured for each case.

As the scintillator characteristics, α ray-excited scintillator emission quantity was measured. ²⁴¹Am was used as a source of α rays. PMT (trade name: R7600, manufactured by Hamamatsu Photonics K.K.) was used as a light receiving element. Five surfaces of the polished multilayer body were covered with a Teflon tape so that the scintillation light can be obtained only from one surface. To allow entrance of α rays, a window (1 mm x 1 mm) was left. On the surface from which the scintillation light emits, a PMT was installed. By applying high voltage on the PMT, the signal was amplified and interpreted. The peak value was amplified by pre-amp and the wave shape was sorted by a pulse shape amp. After passing through a multi channel analyzer, it was collected as a signal by a computer, and compared BGO as light emission quantity. The results are given in the Table 1.

**[Table 1]**

| | Small band gap (3.30 eV) | | | Large band gap (3.46 eV) | | | Light emission quantity |
|---|---|---|---|---|---|---|---|
| | Composition | | Thickness | Composition | | Thickness | BGO ratio |
| | x | y | µm | x | y | µm | % |
| Comparative example 1 | 0.00 | 0.00 | 70 | 0.10 | 0.00 | 220 | 65 |
| Example 1 | 0.00 | 0.00 | 50 | 0.10 | 0.00 | 220 | 98 |
| Example 2 | 0.00 | 0.00 | 30 | 0.10 | 0.00 | 220 | 91 |
| Example 3 | 0.00 | 0.00 | 10 | 0.10 | 0.00 | 220 | 86 |
| Example 4 | 0.00 | 0.00 | 5 | 0.10 | 0.00 | 220 | 70 |
| Comparative example 2 | 0.00 | 0.00 | 3 | 0.10 | 0.00 | 220 | - |
| Comparative example 3 | Hydrothermal synthesis substrate | | | | | | 66 |

| | | | | | | | |
|---|---|---|---|---|---|---|---|
| * x and y in the composition column correspond to x and y in the formula of ZnO mixed crystal, i.e., (Zn_{1-x-y}MgₓCd_{y})O. | | | | | | | |

As shown in the Table 1, with respect to the light emission quantity when α rays are irradiated from the ZnO substrate surface side of the multilayer body of Zn_{0.9}Mg_{0.1}O (220 µm)/hydrothermal synthesis ZnO substrate, the light emission quantity of the ZnO substrate having a small band gap, wherein the substrate having a small band gap has a thickness of 5 µm to 50 µm, is greater than the light emission quantity of hydrothermal synthesis substrate alone in the Comparative example 3, and the BGO ratio was from 70% to 98% and therefore the light emission quantity was increased compared to conventional ZnO scintillator. Meanwhile, when ZnO substrate having a small band gap has a thickness of more than 50 µm as shown in the Comparative example 1, the light emission quantity is almost the same as the hydrothermal synthesis substrate. Further, in the Comparative example 2 wherein ZnO substrate having a small band gap has a thickness of less than 5 µm, α rays penetrate the first layer and scintillator emission occurs in the first layer and the second layer, yielding two peaks in the distribution of emission quantity. As such, energy resolution power is reduced.

### <Examples 5 to 8 and Comparative examples 4 to 6>

With the same method as the Example 1, ZnO mixed crystal multilayer body was produced while changing the thickness of the hydrothermal synthesis ZnO substrate. The light emission quantity obtained by irradiation with electronic rays (accelerated voltage: several dozen to several thousand V) is given in the Table 2.

**[Table 2]**

| | Small band gap (3.30 eV) | | | Large band gap (3.46 eV) | | | Light emission quantity |
|---|---|---|---|---|---|---|---|
| | Composition | | Thickness | Composition | | Thickness | BGO ratio |
| | x | y | µm | x | y | µm | % |
| Comparative Example 4 | 0.00 | 0.00 | 70 | 0.10 | 0.00 | 220 | 61 |
| Example 5 | 0.00 | 0.00 | 50 | 0.10 | 0.00 | 220 | 101 |
| Example 6 | 0.00 | 0.00 | 30 | 0.10 | 0.00 | 220 | 93 |
| Example 7 | 0.00 | 0.00 | 10 | 0.10 | 0.00 | 220 | 87 |
| Example 8 | 0.00 | 0.00 | 5 | 0.10 | 0.00 | 220 | 80 |
| Comparative example 5 | 0.00 | 0.00 | 3 | 0.10 | 0.00 | 220 | - |
| Comparative example 6 | Hydrothermal synthesis substrate | | | | | | 60 |

| | | | | | | | |
|---|---|---|---|---|---|---|---|
| * x and y in the composition column correspond to x and y in the formula of ZnO mixed crystal, i.e., (Zn_{1-x-y}MgₓCd_{y})O. | | | | | | | |

As shown in the Table 2, with respect to the light emission quantity when electronic rays are irradiated from the ZnO substrate surface side of the multilayer body of Zn_{0.9}Mg_{0.1}O (220 µm)/hydrothermal synthesis ZnO substrate, the light emission quantity of the ZnO substrate having a small band gap, wherein the substrate has a thickness of 5 µm to 50 µm, is greater than the light emission quantity of hydrothermal synthesis substrate alone in the Comparative example 6, and the BGO ratio was from 80% to 101%, and therefore the light emission quantity was increased compared to conventional ZnO scintillator. Meanwhile, when ZnO substrate having a small band gap has a thickness of more than 50 µm as shown in the Comparative example 4, the light emission quantity is almost the same as the hydrothermal synthesis substrate. Further, in the Comparative example 5 wherein ZnO substrate having a small band gap has a thickness of less than 5 µm, α rays penetrate the first layer and scintillator emission occurs in the first layer and the second layer, yielding two peaks in the distribution of emission quantity. As such, energy resolution power is reduced.

### <Examples 9 to 13 and Comparative example 7>

With reference to the method of the Example 1, the band gap of ZnO mixed crystal layer having a large band gap was changed in this example without changing the thickness of each layer, i.e., the hydrothermal synthesis ZnO substrate layer (thickness: 30 µm) and a ZnO mixed crystal layer (thickness: 220 µm). Composition, band gap, and light emission quantity for each multilayer body are given in the Table 3.

**[Table 3]**

| | Small band gap (3.30 eV) | | | Large band gap | | | | Light emission quantity |
|---|---|---|---|---|---|---|---|---|
| | Composition | | Thick ness | Composition | | Eg | Thick ness | BGO ratio |
| | x | y | µm | x | y | eV | µm | % |
| Example 9 | 0.000 | 0.000 | 30 | 0.012 | 0.000 | 3.32 | 220 | 70 |
| Example 10 | 0.000 | 0.000 | 30 | 0.050 | 0.000 | 3.38 | 220 | 82 |
| Example 11 | 0.000 | 0.000 | 30 | 0.100 | 0.000 | 3.46 | 220 | 91 |
| Example 12 | 0.000 | 0.000 | 30 | 0.130 | 0.000 | 3.52 | 220 | 103 |
| Example 13 | 0.000 | 0.000 | 30 | 0.145 | 0.000 | 3.54 | 220 | 119 |
| Comparative example 7 | 0.000 | 0.000 | 30 | 0.180 | 0.000 | - | 220 | - |

| | | | | | | | | |
|---|---|---|---|---|---|---|---|---|
| *Example 11 = Example 2 * x and y in the composition column correspond to x and y in the formula of ZnO mixed crystal, i.e., (Zn_{1-x-y}MgₓCd_{y})O. | | | | | | | | |

As shown in the Table 3, with respect to the multilayer body of Zn₁₋ₓMgₓO (220 µm) /hydrothermal synthesis ZnO substrate (30 µm), the multilayer body manufactured by using Zn₁₋ₓMgₓO mixed crystal layer to be the range of 0 ≤ x ≤ 0.145 (i.e., Examples 9 to 13) can have a larger band gap than the hydrothermal synthesis ZnO substrate. As a result, when α rays are irradiated from the ZnO substrate side of the hydrothermal synthesis ZnO substrate, it becomes possible to increased the light emission quantity with BGO ratio of from 70 to 119%. On the other hand, when composition x is greater than 0.145 like the Comparative example 7, precipitation of a single phase MgO occurs, and therefore it is impossible to achieve LPE growth of the mixed crystal layer only.

### <Examples 14 to 17 and Comparative example 8>

With reference to the method of the Example 1, the band gap of ZnO mixed crystal layer having a small band gap was changed in this example without changing the thickness of each layer, i.e., the hydrothermal synthesis ZnO substrate layer (thickness: 500 µm) and ZnO mixed crystal layer (thickness: 30 µm). Composition, band gap, and light emission quantity for each multilayer body are given in the Table 4.

**[Table 4]**

| | Small band gap | | | | Large band gap (3.30 eV) | | | Light emission quantity |
|---|---|---|---|---|---|---|---|---|
| | Composition | | Eg | Thick ness | Composition | | Thick ness | BGO ratio |
| | x | y | eV | µm | x | y | µm | % |
| Example 14 | 0.000 | 0.010 | 3.26 | 30 | 0.000 | 0.000 | 500 | 75 |
| Example 15 | 0.000 | 0.030 | 3.17 | 30 | 0.000 | 0.000 | 500 | 86 |
| Example 16 | 0.000 | 0.050 | 3.09 | 30 | 0.000 | 0.000 | 500 | 101 |
| Example 17 | 0.000 | 0.070 | 3.00 | 30 | 0.000 | 0.000 | 500 | 135 |
| Comparative example 8 | 0.000 | 0.090 | - | 30 | 0.000 | 0.000 | 500 | - |

| | | | | | | | | |
|---|---|---|---|---|---|---|---|---|
| * x and y in the composition column correspond to x and y in the formula of ZnO mixed crystal, i.e., (Zn₁₋ₓ₋yMgₓCd_{y})O. | | | | | | | | |

As shown in the Table 4, with respect to the multilayer body Zn_{1-y}Cd_{y}O (30 µm) /hydrothermal synthesis ZnO substrate (500 µm), the multilayer body manufactured by using Zn_{1-y}Cd_{y}O mixed crystal layer to be the range of 0 ≤ y ≤ 0.07 (i.e., Examples 14 to 17) can have a smaller band gap than the hydrothermal synthesis ZnO substrate. As a result, when α rays are irradiated from the Zn_{1-y}Cd_{y}O mixed crystal layer, it becomes possible to increase the light emission quantity with BGO ratio of from 75 to 135%. On the other hand, when composition y is greater than 0.07 like the Comparative example 8, precipitation of a single phase CdO occurs, and therefore it is impossible to achieve LPE growth of the mixed crystal layer only.

### <Example 18>

According to the same method as the Example 1, LPE growth of Zn_{0.9}Mg_{0.1}O was performed on a hydrothermal synthesis ZnO substrate followed by complete removal of the hydrothermal synthesis ZnO substrate to obtain the thin film of Zn_{0.9}Mg_{0.1}O only. Next, by using the thin film as a substrate, LPE growth of Ga-doped ZnO layer in which ZnO is doped with 59 ppm of Ga₂O₃ was performed. Thereafter, polishing was carried out again to obtain a multilayer body of Zn_{0.9}Mg_{0.1}O layer (220 µm) /Ga-doped ZnO layer (30 µm).

When α rays are irradiated from the Ga-doped ZnO layer having a small band gap, the light emission quantity with BGO ratio of 90% was obtained like the Example 1. Further, when α ray-irradiated transmission spectrum was obtained with this multilayer body, long-wavelength light components in the range of 450 to 600 nm were not observed. From these results, it is found that, by forming a ZnO multilayer body and adjusting thickness of a layer irradiated with ionization radiation such as α rays to 5 µm to 50 µm, the light emission quantity can be increased to about 90% in terms of BGO ratio according to irradiation of ionization radiation. Further, when an element of Group III of the Periodic Table such as Ga is added to the ZnO single crystal irradiated with ionization radiation such as α rays, long-wavelength light components in the range of 450 to 600 nm can be also reduced, and therefore it is possible to improve discrimination function of ionization radiation such as α rays.

### EXPLANATION OF REFERENCE NUMERALS

- 1: Top heater
- 2: Middle heater
- 3: Bottom heater
- 4: Platinum crucible
- 5: Pulling-up shaft
- 6: Substrate holder
- 7: Substrate
- 9: Crucible board
- 11: Furnace tube
- 12: Furnace cover

## Claims

1. A multilayer ZnO single crystal scintillator which is a multilayer body comprising at least two layers of ZnO mixed crystal (Zn_{1-x-y}MgₓCd_{y})O having different band gaps, wherein the ZnO mixed crystal layer with a smaller band gap has an irradiation surface for ionization radiation, thickness of 5 µm to 50 µm, and 0 ≤ x 0.145 and 0 ≤ y ≤ 0.07.

2. The multilayer ZnO single crystal scintillator according to Claim 1, wherein the ionization radiation is α rays.

3. The multilayer ZnO single crystal scintillator according to Claim 1, wherein the ionization radiation is electronic rays.

4. The multilayer ZnO single crystal scintillator according to any one of Claims 1 to 3, comprising at least one selected from a group including Al, Ga, In, H, F and lanthanoid.

5. A method for manufacturing a multilayer ZnO single crystal scintillator which is a multilayer body comprising at least two layers of ZnO mixed crystal (Zn₁₋ₓ₋ymgₓCd_{y})o having different band gaps, wherein the ZnO mixed crystal layer with a smaller band gap has an irradiation surface for ionization radiation, thickness of 5 µm to 50 µm, and 0 ≤ x ≤ 0.145 and 0 ≤ y ≤ 0.07, wherein at least one layer of the multilayer body is produced by a liquid phase epitaxial growth method which includes directly contacting a substrate with a mixture · molten material of ZnO, MgO and CdO as a solute and PbO and Bi₂O₃ as a solvent to grow ZnO mixed crystal (Zn_{1-x-y}MgₓCd_{y})O on the substrate.

6. The method for manufacturing a multilayer ZnO single crystal scintillator according to Claim 5, wherein mixing ratio between the solute and solvent is such that the solute expressed in terms of only ZnO : solvent = 5 to 30 mol% : 95 to 70 mol%, and mixing ratio between PbO and Bi₂O₃ as a solvent is such that the PbO : Bi₂O₃ = 0.1 to 95 mol% : 99.9 to 5 mol%.

7. A method for manufacturing a multilayer ZnO single crystal scintillator which is a multilayer body comprising at least two layers of ZnO mixed crystal (Zn_{1-x-y}MgₓCd_{y})O having different band gaps, wherein the ZnO mixed crystal layer with a smaller band gap has an irradiation surface for ionization radiation, thickness of 5 µm to 50 µm, and 0 ≤ x ≤ 0.145 and 0 ≤ y ≤ 0.07, and at least one layer of the multilayer body is produced by a liquid phase epitaxial growth method which includes directly contacting a substrate with a mixture · molten material of ZnO, MgO and CdO as a solute and PbF₂ and PbO as a solvent to grow ZnO mixed crystal (Zn_{1-x-y}MgₓCd_{y})O on the substrate.

8. The method for manufacturing a multilayer ZnO single crystal scintillator according to Claim 7, wherein mixing ratio between the solute and solvent is such that the solute expressed in terms of only ZnO : solvent = 2 to 20 mol% : 98 to 80 mol%, and mixing ratio between PbF₂ and PbO as a solvent is such that PbF₂ : PbO = 80 to 20 mol% : 20 to 80 mol%.

9. The method for manufacturing a multilayer ZnO single crystal scintillator according to any one of Claims 5 to 8, wherein ZnO mixed crystal (Zn_{1-x-y}MgₓCd_{y})O having different composition from the ZnO mixed crystal (Zn_{1-x-y}MgₓCd_{y})O of a substrate is grown on the ZnO mixed crystal substrate to manufacture a multilayer body, and thickness of ZnO mixed crystal layer having a smaller band gap is adjusted to 5 µm to 50 µm by polishing or etching.
